# EUROPÄISCHE PATENTSCHRIFT

(11) **EP 2 316 254 B1**
(45) Veröffentlichungstag und Bekanntmachung des Hinweises auf die Patenterteilung: **11.01.2017**
(21) Anmeldenummer: 09780065.0
(22) Anmeldetag: 01.07.2009
(51) Int. Cl.: H05K 7/14, H05K 7/20, B25F 5/00

(54) **ELEKTRONIKMODUL**
ELECTRONIC MODULE
MODULE ÉLECTRONIQUE

(30) Priorität: 20.08.2008 DE 102008041366
(43) Veröffentlichungstag der Anmeldung: 04.05.2011
(73) Patentinhaber: Robert Bosch GmbH, 70442 Stuttgart (DE)
(72) Erfinder: SINGLE, Ulrich, Penang 11900 (MY); MEYER, Michael, 70374 Stuttgart (DE); GUENTHER, Klaus, 70567 Stuttgart (DE); LOHNER, Martin, 72406 Bietigheim-Bissingen (DE); DENGLER, Klaus, 70806 Kornwestheim (DE)
(86) Internationale Anmeldenummer: PCT/EP2009/058273
(87) Internationale Veröffentlichungsnummer: WO 2010/020459

(56) Entgegenhaltungen:
- WO-A-03/017742
- DE-A1- 19 719 942
- US-A- 5 946 192
- US-A1- 2001 012 212
- US-A1- 2007 079 980

## Beschreibung

### Stand der Technik

Die Erfindung geht aus von einem Handwerkzeugmaschinenelektronikmodul nach dem Oberbegriff des Anspruchs 1.

Aus der Druckschrift WO 03/017742 A1 ist ein Handwerkzeugmaschinenelektronikmodul eines Elektrowerkzeugs mit einem Elektronikmodulgehäuse und einer Leiterplatte bekannt, wobei die Leiterplatte relativ zu einem Gehäusebauteil des Elektronikmodulgehäuses in Bezug auf eine Temperatur und einen Stromfluss durch eine Umhüllmasse entkoppelt ist.

Die Druckschrift US 2001//0012212 A1 lehrt ein Kraftfahrzeugelektronikmodul, das Gleichstrom in Wechselstrom umwandelt und einen Kompressor einer Klimaanlage eines Kraftfahrzeugs versorgt.

Aus der Druckschrift US 2007/0079980 A1 ist ein Handwerkzeugmaschinenelektronikmodul bekannt, das ein Elektronikmodulgehäuse, eine Leiterplatte, eine Kühlvorrichtung und einen Abstandshalter umfasst, wobei der Abstandshalter die Leiterplatte von der Kühlvorrichtung beabstandet und ein Umhüllungsmaterial, wie beispielsweise Epoxydharz, Urethan, Urethan-Gel, Silikon oder Silikon-Gel, aufweist.

### Vorteile der Erfindung

Es wird ein Handwerkzeugmaschinenelektronikmodul mit einem Elektronikmodulgehäuse, mit zumindest einer Leiterplatte, wobei die zumindest eine Leiterplatte relativ zu zumindest einem Gehäusebauteil des Elektronikmodulgehäuses in Bezug auf eine Bewegung und/oder eine Temperatur und/oder einen Stromfluss entkoppelt ist, mit zumindest einer Kühlvorrichtung, die zumindest ein Gehäusebauteil bildet, mit zumindest einem aus Metall gebildeten Abstandshalter, der die zumindest eine Leiterplatte von der zumindest einen Kühlvorrichtung beabstandet, und mit zumindest einem Halbleiter mit zumindest einem Halbleitergehäuse, das zumindest ein Befestigungselement aufweist, vorgeschlagen, wobei das zumindest eine Befestigungselement zumindest den zumindest einen Halbleiter positioniert, wobei der Halbleiter direkt an der Kühlvorrichtung angeordnet ist,
wobei der zumindest eine Abstandshalter eine thermische Kopplung zwischen zumindest dem zumindest einen Halbleiter und der zumindest einen Leiterplatte bildet, wobei die zumindest eine Leiterplatte eine Messvorrichtung zu einer indirekten Ermittlung bzw. Messung einer Temperatur des Halbleiters mittels der thermischen Kopplung zwischen zumindest dem zumindest einen Halbleiter und der zumindest einen Leiterplatte aufweist. In diesem Zusammenhang soll unter einem "Elektronikmodul" insbesondere eine Einheit verstanden werden, die zumindest ein Elektronikbauteil, wie beispielsweise eine Leiterplatte, eine Diode, einen Transistor, einen Kondensator, einen Heiß- und/oder Kaltleiter, einen Sensor, einen Widerstand und/oder ein anderes, dem Fachmann als zweckdienlich erscheinendes Bauteil aufweist und/oder das zu einer elektronischen Schaltung einer weiteren Einheit der Handwerkzeugmaschine, wie etwa einer Motoreinheit, vorgesehen ist. Bevorzugt ist das Elektronikmodul von einem Drehzahlregler gebildet und/oder innerhalb eines Handwerkzeugmaschinengehäuses der Handwerkzeugmaschine angeordnet. Grundsätzlich wäre jedoch auch die Schaltung einer anderen, dem Fachmann als sinnvoll erscheinenden Einheit, wie etwa einer Beleuchtungseinheit und/oder einer Ventileinheit und/oder einer Zündspuleneinheit etc., möglich. Unter einer "Leiterplatte" soll hier insbesondere eine Platine und/oder ein Träger aus isolierendem Material verstanden werden, auf den ein elektrisch leitendes Material aufgebracht ist und/oder der zu einer mechanischen Befestigung und/oder elektrischen Verbindung von Bauteilen, insbesondere Elektronikbauteilen, mittels einem Kleb- und/oder einem Klemm- und/oder einem Schweiß- und/oder insbesondere einem Lötvorgang dient. Grundsätzlich wäre jedoch auch ein anderes Verfahren zur Befestigung und/oder Verbindung denkbar. Ein "Gehäusebauteil" stellt hier insbesondere ein Bestandteil des Elektronikmodulgehäuses dar, wobei das "Elektronikmodulgehäuse" des Elektronikmoduls hier insbesondere eine Struktur definiert, die eine Gesamtheit der Bauteile des Elektronikmoduls vollständig bzw. an zumindest sechs Seiten umgibt und/oder das Elektronikmodul von anderen Komponenten, wie beispielsweise der Motoreinheit, einer Getriebeeinheit und/oder anderen, sich innerhalb des Handwerkzeugmaschinengehäuses angeordneten Komponenten, trennt und/oder verschieden von einem Handwerkzeugmaschinengehäuse ausgebildet ist. Zudem ist das Gehäusebauteil insbesondere dazu vorgesehen, zumindest ein Bauteil des Elektronikmoduls zu umschließen und/oder zu lagern und/oder zu tragen und/oder zu kühlen, wobei unter "vorgesehen" speziell ausgestattet und/oder ausgelegt verstanden werden soll. In diesem Zusammenhang soll unter der Wendung "zumindest teilweise entkoppelt" insbesondere verstanden werden, dass die Leiterplatte in zumindest einer Hinsicht bzw. einem Energiefluss, wie beispielsweise einer Bewegung und/oder einer Temperatur und/oder einem Stromfluss, von dem Gehäusebauteil zu bevorzugt mehr als 75 %, vorteilhaft zu mehr als 85 % und besonders bevorzugt zu mehr als 95 % unabhängig ist und/oder zumindest ein Mittler und/oder Bauteil, wie beispielsweise ein weiteres Gehäusebauteil, in räumlicher Hinsicht zwischen der Leiterplatte und dem Gehäusebauteil angeordnet ist.

In diesem Zusammenhang soll unter einer "Kühlvorrichtung" insbesondere eine Vorrichtung, wie beispielsweise ein Gebläse und/oder insbesondere ein speziell ausgebildeter Körper, beispielsweise in der Form einer Öffnung und/oder einer Kühlrippe und/oder einer Platte und/oder insbesondere einer metallischen U-Profilplatte, verstanden werden, der zu einer Kühlung dient und/oder der dazu vorgesehen ist, Wärme aufzunehmen und/oder abzuleiten. Die Kühlvorrichtung besitzt die Form eines umgedrehten U und stellt ein zweites Gehäusebauteil dar und bildet zusammen mit dem ersten Gehäusebauteil das Elektronikmodulgehäuse. Ferner ist das zweite Gehäusebauteil bezüglich eines möglichen Energieflusses zwischen der Leiterplatte und dem ersten Gehäusebauteil angeordnet und stellt die elektrische und/oder thermische und/oder die bewegliche Entkopplung der Leiterplatte gegenüber dem ersten Gehäusebauteil dar. Unter einem "Abstandshalter" soll insbesondere ein Element verstanden werden, das dazu dient, eine räumliche Anordnung zu vermitteln, durch die verhindert wird, dass zwischen Bauteilen des Elektronikmoduls und insbesondere zwischen der Leiterplatte und der Kühlvorrichtung ein Kontakt und/oder eine Berührung zustande kommt. Vorteilhafterweise kontaktiert der Abstandshalter die Leiterplatte und die Kühlvorrichtung jeweils direkt.

Unter einem "Halbleiter" soll hier insbesondere ein Bauteil, wie eine Diode, ein Thyristor, ein TRIAC, eine MOSFET, ein IGBT-Bauteil und/oder ein anderes, dem Fachmann als zweckdienlich erscheinendes Bauteil verstanden werden, das elektrisch leitende und nicht leitende Eigenschaften aufweist und/oder das dazu dient, Strom und/oder Spannung zu leiten und/oder zu schalten und/oder zu steuern. Der Halbleiter ist bevorzugt als Leistungshalbleiter in der Form eines TRIACs ausgebildet. Ein "Halbleitergehäuse" definiert hierbei ein räumliches Gebilde, das den Halbleiter vollständig bzw. an zumindest sechs Seiten umgibt. Bevorzugt ist das Halbleitergehäuse von einem TO220-Gehäuse gebildet und zu einer guten Wärmeleitung aus Metall gefertigt. Ein "Befestigungselement" stellt hier bevorzugt ein Element, wie beispielsweise eine Lasche mit einer Aussparung, dar, das zu einer Befestigung des Halbleiters an einem anderen Bauteil dient und/oder das einstückig mit dem Halbleitergehäuse ausgebildet ist, wobei einstückig hier bedeutet, dass das Befestigungselement und das Halbleitergehäuse in einem gemeinsamen Gussverfahren herstellbar sind. Unter "positionieren" soll in diesem Zusammenhang insbesondere verstanden werden, dass eine exakte Position und/oder Ausrichtung des Halbleiters durch das Befestigungselement gewährleistet wird. In diesem Zusammenhang soll unter einer "thermischen Kopplung" eine Kopplung bzw. eine Bauteilverbindung verstanden werden, die insbesondere gezielt dazu vorgesehen ist, Wärme zu leiten und/oder deren Wärmeleitfähigkeit besser als 3 [W/(m*K)], bevorzugt besser als 10 [W/(m*K)] und besonders bevorzugt besser als 15 [W/(m*K)] beträgt. Hier beinhaltet der Terminus "Halbleiter" auch das Halbleitergehäuse.

Durch die erfindungsgemäße Ausgestaltung kann konstruktiv einfach eine vorteilhafte mechanisch spannungsfreie Lagerung bzw. Aufhängung der Leiterplatte gewährleistet werden. Mittels der Kühlvorrichtung und vor allem durch die Ausgestaltung als Gehäusebauteil kann zudem zum einen eine kompakte Bauform und zum anderen eine optimale und vorteilhafte Kühlung mit einer großen Kühlfläche und dadurch ein verlässlicher Betrieb des Elektronikmoduls bereitgestellt werden. Durch den Abstandshalter kann die Leiterplatte konstruktiv einfach in Bezug auf die Kühlvorrichtung in einem fixen und exakten Abstand angeordnet werden. Durch den Halbleiter kann eine robuste Steuerung des Elektronikmoduls bereitgestellt werden, der mittels des Halbleitergehäuses geschützt gelagert und mittels des Befestigungselements sicher positioniert und befestigt werden kann. Mittels der thermischen Kopplung kann indirekt eine Ermittlung bzw. Messung einer Temperatur des Halbleiters erfolgen. Dafür weist die Leiterplatte eine Messvorrichtung, wie einen Heißleiter bzw. ein NTC, auf, der bevorzugt auf der Leiterplatte als SMD-Bauteil ausgebildet ist, wodurch eine Bauteil, Kosten und Montageaufwand sparende Möglichkeit eröffnet wird, eine Temperatur des Halbleiters zu ermitteln.

Des Weiteren wird vorgeschlagen, dass das zumindest eine Gehäusebauteil zumindest einen Aufnahmebereich für die zumindest eine Leiterplatte bildet. Unter einem "Aufnahmebereich" soll hier insbesondere ein räumliches Gebilde, insbesondere ein topfförmiges Gebilde, verstanden werden, das einen Hohlraum bildet, in dem zumindest die Leiterplatte vollständig aufgenommen wird und/oder das den Hohlraum an zumindest zwei Seiten, bevorzugt an fünf Seiten begrenzt. Es können auch andere Bauteile des Elektronikmoduls in dem Aufnahmebereich aufgenommen sein. Vorteilhafterweise ist das Gehäusebauteil aus Kunststoff gebildet und stellt ein erstes Gehäusebauteil dar und/oder bildet eine Montagevorrichtung zur Befestigung des Elektronikmoduls an dem Handwerkzeugmaschinengehäuse und/oder an der Motoreinheit. Durch die Realisierung des Aufnahmebereichs kann die Leiterplatte vorteilhaft vollständig und geschützt im Gehäusebauteil des Elektronikmoduls angeordnet bzw. montiert werden.

In einem weiteren Aspekt der Erfindung wird vorgeschlagen, dass die zumindest eine Leiterplatte über den zumindest einen Abstandshalter mit der zumindest einen Kühlvorrichtung verbunden ist. Hierbei sind grundsätzlich sämtliche, dem Fachmann als sinnvoll erscheinende Verbindungsarten, wie ein Kraft- und/oder Form- und/oder Stoffschluss denkbar. Durch die erfindungsgemäße Ausgestaltung kann eine konstruktiv einfache Verbindung zwischen der Leiterplatte und dem Kühlvorrichtung erreicht werden.

Ferner wird vorgeschlagen, dass zumindest der zumindest eine Abstandshalter über einen Einpressvorgang mit der zumindest einen Leiterplatte verbunden ist. Unter einem "Einpressvorgang" soll hier insbesondere ein Vorgang verstanden werden, der auf einem Stoffschluss beruht und/oder mittels dem der Abstandshalter untrennbar, bevorzugt auf atomarer Ebene, mit der Leiterplatte verbunden wird. Mittels des Einpressvorgangs kann eine fixe und unveränderbare Position der Leiterplatte relativ zum Abstandshalter erzielt werden, wodurch diese beiden Bauteile vorteilhaft als eine kompakte Baugruppe befestigt werden können.

Des Weiteren kann es vorteilhaft sein, wenn der zumindest eine Abstandshalter über einen Kraftschluss mit der zumindest einen Kühlvorrichtung verbunden ist, wodurch eine stabile und sichere Verbindung der beiden Bauteile realisiert werden kann. Ferner kann durch den Kraftschluss ein bisher üblicher Vergussprozess zu einer Befestigung der Bauteile des Elektronikmoduls, wie der Leiterplatte und der Kühlvorrichtung, untereinander vermieden werden, was eine nachteilige Veränderung der Position der Komponenten zueinander verhindert.

Zudem können die Bauteile des Elektronikmoduls konstruktiv einfach montiert werden, wenn der zumindest eine Abstandshalter mit der zumindest einen Kühlvorrichtung über eine lösbare Verbindung verbunden ist. In diesem Zusammenhang soll unter einer "lösbaren Verbindung" eine Verbindung, wie eine Rast- und/oder insbesondere eine Schraubverbindung, verstanden werden, die, ohne einen Funktionsverlust der miteinander verbundenen Bauteile bzw. des Abstandshalters und der Kühlvorrichtung hervorzurufen, gelöst werden kann.

Vorteilhafterweise ist die lösbare Verbindung eine Schraubverbindung, die von einer Senkkopfschraube vermittelt wird. Die Senkkopfschraube greift in ein Innengewinde, das in einer Ausnehmung des Abstandshalters angeordnet ist, ein, wodurch vorteilhaft eine automatische Zentrierung des Abstandshalters und der an ihn angeordneten Komponenten, wie beispielsweise der Leiterplatte, ermöglicht wird.

Eine bevorzugte Weiterbildung besteht darin, dass der zumindest eine Halbleiter über eine von dem zumindest einen Abstandshalter vermittelte Klemmverbindung mit der zumindest einen Kühlvorrichtung verbunden ist. In diesem Zusammenhang soll unter einer "vom Abstandshalter vermittelten Klemmverbindung" eine kraftschlüssige Verbindung verstanden werden, die dadurch vermittelt wird, dass eine von der Leiterplatte abgewandte Oberseite des Abstandshalters durch die Schraubverbindung an eine der Leiterplatte zugewandten Oberfläche des Befestigungselements angedrückt wird und damit das Halbleitergehäuse über das Befestigungselement an eine zur Leiterplatte weisenden Unterseite der Kühlvorrichtung gedrückt wird. Somit dient der Abstandshalter durch seine Wirkverbindung mit der Senkschraube vorteilhaft sowie Bauteil, Kosten und Montageaufwand sparend zusätzlich als Befestigungselement für das Halbleitergehäuse bzw. den Halbleiter, wodurch zudem eine mechanisch spannungsfreie Befestigung des Halbleiters gewährleistet wird. Ferner erfährt der Halbleiter durch seine Anordnung direkt an der Kühlvorrichtung eine vorteilhafte und effiziente Kühlung.

Des Weiteren wird vorgeschlagen, dass der zumindest eine Abstandshalter die zumindest eine Leiterplatte zumindest relativ zu dem Gehäusebauteil zentriert. In diesem Zusammenhang soll unter der Wendung "relativ zu dem Gehäusebauteil zu zentrieren" insbesondere verstanden werden, dass eine Symmetrie der Leiterplatte in Bezug auf eine Ebene des Gehäusebauteils, die sich parallel zu den beiden Schenkeln des U der Kühlvorrichtung bzw. des zweiten Gehäusebauteils erstreckt, mit Hilfe des Abstandshalters bzw. seiner Befestigung durch die Senkkopfschraube hergestellt wird. Generell wäre jedoch auch eine unzentrierte Anordnung denkbar. Durch die Zentrierung der Leiterplatte kann diese in eine vorteilhaft vorbestimmte und fixe Position relativ zu den anderen Bauteilen des Elektronikmoduls gebracht werden, wodurch beispielsweise Schnittstellen, wie etwa Anschlussleitungen bzw. Kabel, einfach an der Leiterplatte und auch am ersten Gehäusebauteil befestigt werden können.

In einer weiteren Ausgestaltung der Erfindung wird eine Handwerkzeugmaschine mit zumindest einem Elektronikmodul vorgeschlagen, wobei die Anwendung des Elektronikmoduls grundsätzlich für sämtliche dem Fachmann für sinnvoll erscheinende Handwerkzeugmaschinen und insbesondere für Handwerkzeugmaschinen mit drehbar angetriebenen Werkzeugen denkbar wäre.

### Zeichnung

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: eine Handwerkzeugmaschine mit einem erfindungsgemäßen Elektronikmodul,
- Fig. 2: das Elektronikmodul aus Figur 1 in seine Einzelteile zerlegt,
- Fig. 3: das Elektronikmodul aus Figur 1 in zusammengebautem Zustand in einer Schnittdarstellung von vorne,
- Fig. 4: das Elektronikmodul aus Figur 1 in zusammengebautem Zustand in einer Schnittdarstellung von der Seite und
- Fig. 5: das Elektronikmodul aus Figur 1 in zusammengebautem Zustand in einer Seitenansicht.

### Beschreibung des Ausführungsbeispiels

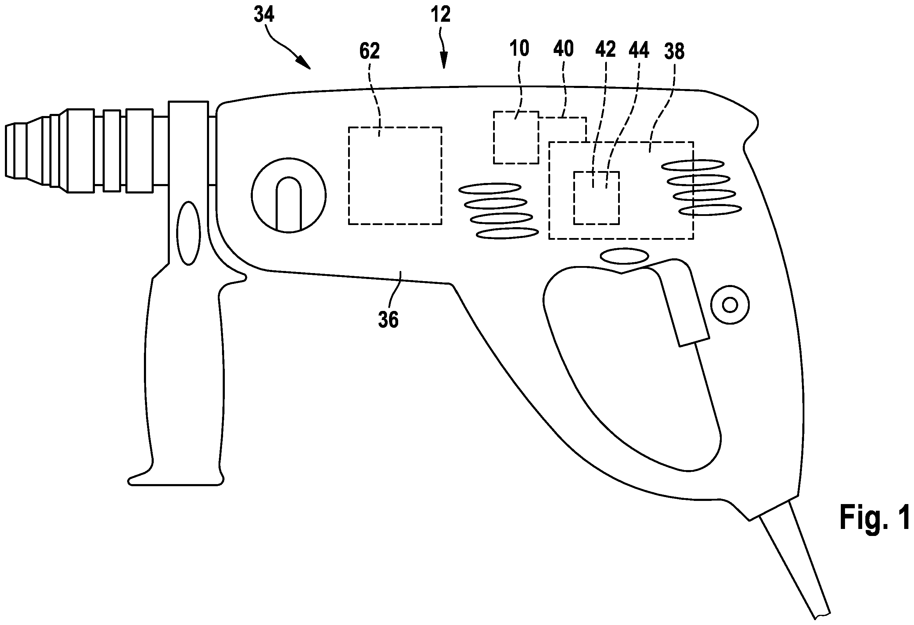

Figur 1 zeigt eine Handwerkzeugmaschine 12 in der Form eines Bohrhammers 34 mit einem Handwerkzeugmaschinengehäuse 36, einer Motoreinheit 38 und mit einem erfindungsgemäßen Elektronikmodul 10, das in dem Handwerkzeugmaschinengehäuse 36 angeordnet und über elektrische Leitungen 40 mit der Motoreinheit 38 verbunden ist. Das Elektronikmodul 10 stellt einen Drehzahlregler 42 dar, der eine Drehzahl eines Motors 44 der Motoreinheit 38 steuert und regelt.

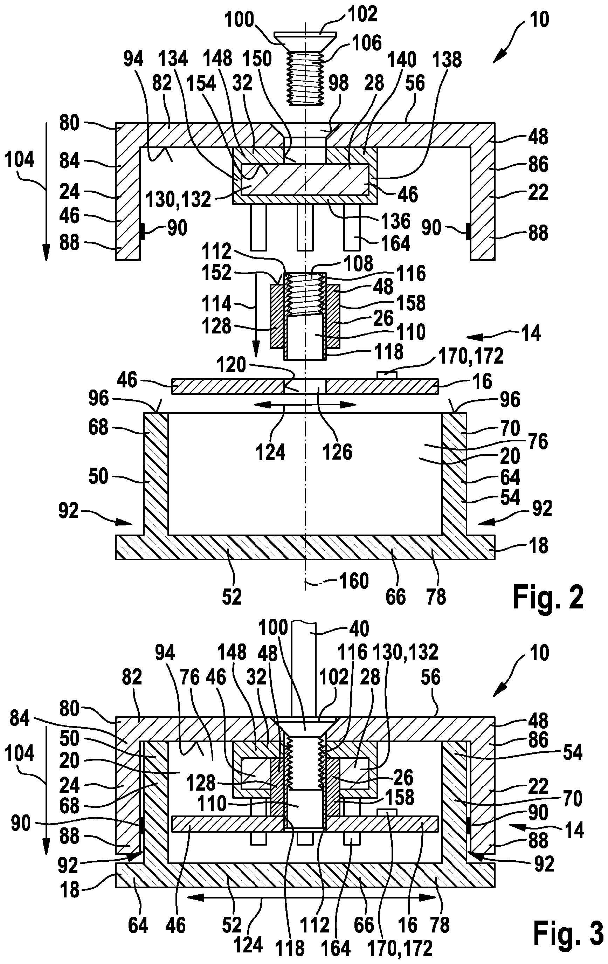

In der Figur 2 ist eine Detaildarstellung des Elektronikmoduls 10 in seine Einzelteile zerlegt gezeigt. Das Elektronikmodul 10 weist ein Elektronikmodulgehäuse 14, das sich aus einem ersten Gehäusebauteil 18 und einem zweiten Gehäusebauteil 24 zusammensetzt, einen Abstandshalter 26 und mehrere Elektronikbauteile 46 in der Form einer Leiterplatte 16 und eines Halbleiters 28 auf. Ferner weist das Elektronikmodul 10 eine Kühlvorrichtung 22 auf, die von dem Gehäusebauteil 24 gebildet wird. Indem die Leiterplatte 16 weder bezogen auf eine Bewegung noch hinsichtlich eines Temperaturflusses mit dem ersten Gehäusebauteil 18 direkt verbunden ist, ist die Leiterplatte 16 relativ zu dem Gehäusebauteil 18 des Elektronikmodulgehäuses 14 zumindest teilweise entkoppelt. Diese Entkopplung erfolgt über einen Mittler 48, der zum einen von dem zweiten Gehäusebauteil 24 und zum anderen von dem Abstandshalter 26, der die Leiterplatte 16 von der Kühlvorrichtung 22 beabstandet, gebildet wird.

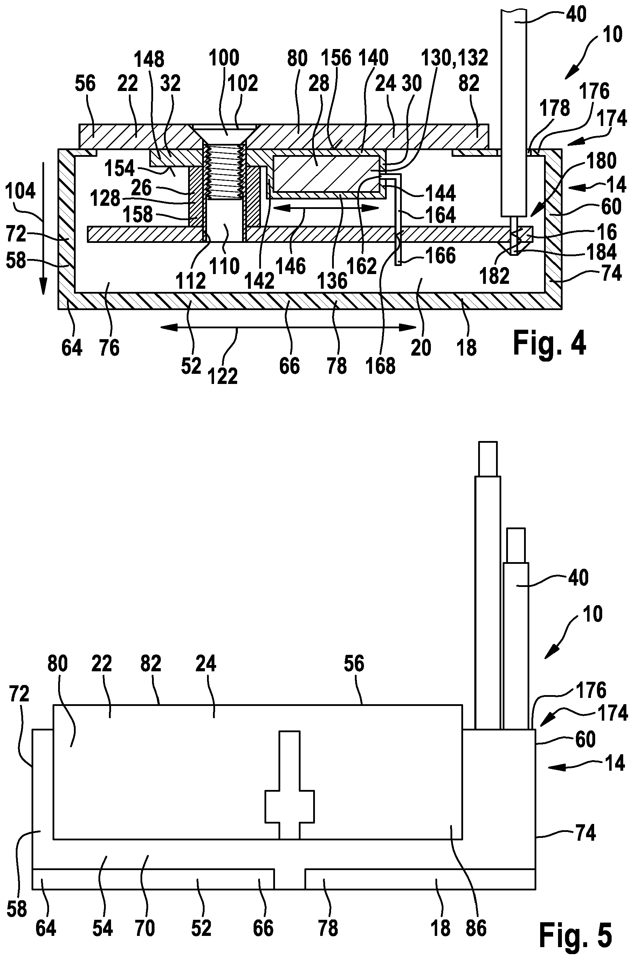

Wie in den Figuren 3 und 4 zu sehen ist, umgibt das Elektronikmodulgehäuse 14 eine Gesamtheit der Bauteile des Elektronikmoduls 10, nämlich die Leiterplatte 16, den Abstandshalter 26 und den Halbleiter 28, an sechs Seiten 50, 52, 54, 56, 58, 60 und trennt dadurch diese Bauteile 16, 26, 28 von anderen, innerhalb des Handwerkzeugmaschinengehäuses 36 angeordneten Komponenten, wie beispielsweise der Motoreinheit 38 oder einer Getriebeeinheit 62 (siehe Figur 1). Das erste Gehäusebauteil 18 des Elektronikmodulgehäuses 14 bildet einen topfförmigen Kunststoffkörper 64, der mit einem Bodenelement 66 und mit vier sich senkrecht zu dem Bodenelement 66 erstreckenden und eine rechteckige Form bildenden Wandungen 68, 70, 72, 74 fünf Seiten 50, 54, 56, 58, 60 des Elektronikmodulgehäuses 14 bildet. Das Bodenelement 66 und die vier Wandungen 68, 70, 72, 74 formen einen Hohlraum 76, sodass das Gehäusebauteil 18 einen Aufnahmebereich 20 für die Leiterplatte 16 bildet. Zudem stellt das erste Gehäusebauteil 18 eine Montagevorrichtung 78 dar, die dazu dient, das Elektronikmodul 10 an dem Handwerkzeugmaschinengehäuse 36 bzw. an der Motoreinheit 38 zu befestigen.

Das Gehäusebauteil 24 ist von einer metallischen U-Profilplatte 80 gebildet, die eine sich parallel zu dem Bodenelement 66 erstreckende Basis 82 und zwei sich senkrecht zu der Basis 82 und sich parallel zu den Wandungen 68, 70 erstreckende Schenkel 84, 86 aufweist. Die parallel zu den Wandungen 68, 70 verlaufenden Schenkel 84, 86 weisen an ihren Endbereichen 88 Rastelemente 90 auf, die in hier nicht näher dargestellte Ausnehmungen der Wandungen 68, 70, die in Bereichen 92 in der Nähe des Bodenelements 66 angeordnet sind, eingreifen, um das Gehäusebauteil 24 rastend mit dem Gehäusebauteil 18 zu verbinden (siehe Figur 3). Zudem stellt das Gehäusebauteil 24 die sechste Seite 52 des Elektronikmodulgehäuses 14 dar, wobei eine Unterseite 94 des Gehäusebauteils 24 bzw. der Kühlvorrichtung 22 auf einer Oberfläche 96 der Wandungen 68, 70 aufliegt und somit den Aufnahmebereich 20 zu einer verschmutzungsfreien Aufnahme der Komponenten, wie der störanfälligen Leiterplatte 16 und des Halbleiters 28 des Elektronikmoduls 10 zumindest weitgehend verschließt.

Die Kühlvorrichtung 22 bzw. die Basis 82 des Gehäusebauteils 24 weist eine zentrisch zwischen den beiden Schenkeln 84, 86 angeordnete in ihrer Form einer Form einer Senkkopfschraube angepasste Ausnehmung 98 auf, durch die eine Schraube 100, ausgebildet als Senkkopfschraube 102, in eine zum Bodenelement 66 des Gehäusebauteils 18 weisende Richtung 104 geführt ist, um den Abstandshalter 26 über einen Kraftschluss bzw. eine lösbare Schraubverbindung mit der Kühlvorrichtung 22 zu verbinden. Hierzu greift die Schraube 100 mit ihrem Außengewinde 106 in ein Innengewinde 108, das in einer runden Ausnehmung 110 einer inneren zylindrischen Hülse 112 des Abstandshalters 26 ausgebildet ist, ein, wobei die Ausnehmung 110 entlang einer Haupterstreckungsrichtung 114 des Abstandshalter 26 durch diesen verläuft. Dadurch ragt ein zur Kühlvorrichtung 22 weisender Endabschnitt 116 in die Ausnehmung 98 der Kühlvorrichtung 22 und somit stellt der Abstandshalter 26 einen direkten Kontakt mit der Kühlvorrichtung 22 her. Ein dem Endabschnitt 116 in Richtung der Leiterplatte 16 gegenüberliegender Endabschnitt 118 des Abstandshalters 26 stellt eine Verbindung bzw. einen direkten Kontakt zu der Leiterplatte 16 her, wodurch die Leiterplatte 16 über den Abstandshalter 26 mit der Kühlvorrichtung 22 verbunden ist. Hierbei ist der Abstandshalter 26 bzw. der Endabschnitt 118 über einen Einpressvorgang mit der Leiterplatte 16 bzw. mit einem Rand 120 einer bezogen auf eine zu einer Haupterstreckungsrichtung 122 der Leiterplatte 16 senkrechten Richtung 124 zentrisch und bezogen auf die Haupterstreckungsrichtung 122 außermittig in der Leiterplatte 16 angeordneten Ausnehmung 126 verbunden bzw. der Endabschnitt 118 greift in die Ausnehmung 126 ein. Durch den Einpressvorgang bilden die Leiterplatte 16 und der Abstandshalter 26 eine kompakte Baugruppe, die in einem Arbeitsschritt durch Lösen der Schraube 100 von der Kühlvorrichtung 22 getrennt werden kann. Ferner weist der Abstandshalter 26 eine äußerer Hülse 128 auf, die in Haupterstreckungsrichtung 114 des Abstandshalters 26 kürzer ausgebildet ist als die innere Hülse 112 und mit dieser einstückig ausgebildet ist.

Der Halbleiter 28 ist von einem Leistungshalbleiter 130 in der Form eines TRIACs 132 gebildet und an sechs Seiten 134, 136, 138, 140 ,142, 144 von einem Halbleitergehäuse 30 umgeben, das aus Metall gefertigt ist und ein TO220-Gehäuse darstellt. Ferner weist das Halbleitergehäuse 30 ein Befestigungselement 32, in der Form einer sich in eine Haupterstreckungsrichtung 146 des Halbleiters 28 erstreckende Lasche 148 mit einer Aussparung 150, auf, wobei das Befestigungselement 32 dazu vorgesehen ist, den Halbleiter 28 zu positionieren, wodurch sich der Halbleiter 28 zu der Kühlvorrichtung 22 plan-parallel erstreckt. Dazu ist der Endbereich 116 des Abstandshalters 26 durch die Aussparung 150 der Lasche 148 hindurchgeführt, wodurch eine von der Leiterplatte 16 abgewandte Oberfläche 152 des Abstandshalters 26 bzw. der äußeren Hülse 128 durch die Schraubverbindung an eine der Leiterplatte 16 zugewandten Unterseite 154 des Befestigungselements 32 angedrückt wird und damit das Halbleitergehäuse 30 über das Befestigungselement 32 an die zur Leiterplatte 16 weisenden Unterseite 94 der Kühlvorrichtung 22 gedrückt wird. Dadurch liegt eine von der Leiterplatte 16 abgewandte Oberseite 156 des Halbleitergehäuses 30 bzw. des Befestigungselements 32 unmittelbar bzw. mit Kontakt an der zur Leiterplatte 16 weisenden Unterseite 94 der Kühlvorrichtung 22 an. Somit dient der Abstandshalter 26 wegen seiner Wechselwirkung mit der Schraube 100 zusätzlich als ein Befestigungselement 158 und der Halbleiter 28 ist über eine vom Abstandshalter 26 vermittelte Klemmverbindung mit der Kühlvorrichtung 22 verbunden. Ferner ist der Abstandshalter 26 dazu vorgesehen, die Leiterplatte 16 relativ zu den Gehäusebauteilen 18, 24 zu zentrieren, wodurch die Leiterplatte 16 bezogen auf eine Ebene 160, die sich parallel zu den beiden Schenkeln 84, 86 der U-Profilplatte 80 der Kühlvorrichtung 22 bzw. des zweiten Gehäusebauteils 24 erstreckt, symmetrisch ausgebildet ist.

An der von dem Befestigungselement 32 abgewandten Seite 144 des Halbleitergehäuses 30 sind Ausnehmungen 162 ausgebildet, durch die Anschlussstifte 164 greifen, die den Halbleiter 28 mit der Leiterplatte 16 elektrisch verbinden. Dazu sind in Richtung der Leiterplatte 16 weisende Enden 166 der Anschlussstifte 164 durch Ausnehmungen 168 in der Leiterplatte 16 geführt und mit deren Rändern verlötet.

Durch die Fertigung des Abstandshalters 26 aus Metall ist der Abstandshalter 26 dazu vorgesehen, eine thermische Kopplung zwischen dem Halbleiter 28 und der Leiterplatte 16 zu bilden. Diese thermische Kopplung kann dazu genutzt werden, einen Wärmefluss von dem Halbleiter 28 bzw. dem Halbleitergehäuse 30 bzw. dem Befestigungselement 32 durch den Abstandshalter 26 zu der Leiterplatte 16 zu detektieren und so indirekt die Temperatur des Halbleiters 28 über die Temperatur der Leiterplatte 16 zu ermitteln, wozu eine Messvorrichtung 170 in der Form eines NTCs 172 als SMD-Bauteil auf der Leiterplatte 16 angeordnet ist.

Wie in den Figuren 4 und 5 zu sehen ist, weist das Elektronikmodulgehäuse 14 im Bereich der Wandung 74 des Gehäusebauteils 18 einen Bereich 174 auf, der zu einem Großteil unüberdeckt von dem Gehäusebauteil 24 bzw. der Kühlvorrichtung 22 ist und eine Abdeckung 176 aufweist, die parallel zum Bodenelement 66 und senkrecht zu den Wandungen 68, 70, 72, 74 ausgerichtet ist. In der Abdeckung 176 ist eine Ausnehmung 178 angeordnet, durch die die elektrischen Leitungen 40 des Elektronikmoduls 10, von der in der Figur 4 nur eine exemplarisch gezeigt ist, geführt sind. Zur elektrischen Kontaktierung der Leiterplatte 16 weist diese in einem zur Wandung 74 weisenden Endbereich 180 der Leiterplatte 16 Ausnehmungen 182 auf, durch die Kontaktstellen 184 der elektrischen Leitungen 40 geführt sind und mit der Leiterplatte 16 verlötet sind.

In der Figur 5 ist eine Seitenansicht des Elektronikmoduls 10 in einem geschlossenen Zustand gezeigt, wobei hier die Anordnung der Gehäusebauteile 18 und 24 zueinander verdeutlicht wird.

## Patentansprüche

1. Handwerkzeugmaschinenelektronikmodul mit einem Elektronikmodulgehäuse (14), mit zumindest einer Leiterplatte (16), wobei die zumindest eine Leiterplatte (16) relativ zu zumindest einem Gehäusebauteil (18) des Elektronikmodulgehäuses (14) in Bezug auf eine Bewegung und/oder eine Temperatur und/oder einen Stromfluss entkoppelt ist, mit zumindest einer Kühlvorrichtung (22), die zumindest ein Gehäusebauteil (24) bildet, mit zumindest einem aus Metall gebildeten Abstandshalter (26), der die zumindest eine Leiterplatte (16) von der zumindest einen Kühlvorrichtung (22) beabstandet, und mit zumindest einem Halbleiter (28) mit zumindest einem Halbleitergehäuse (30), das zumindest ein Befestigungselement (32) aufweist, wobei das zumindest eine Befestigungselement (32) zumindest den zumindest einen Halbleiter (28) positioniert, wobei der Halbleiter (28) direkt an der Kühlvorrichtung (22) angeordnet ist, wobei der zumindest eine Abstandshalter (26) eine thermische Kopplung zwischen zumindest dem zumindest einen Halbleiter (28) und der zumindest einen Leiterplatte (16) bildet, wobei die zumindest eine Leiterplatte (16) eine Messvorrichtung (170) zu einer indirekten Ermittlung bzw. Messung einer Temperatur des Halbleiters mittels der thermischen Kopplung zwischen zumindest dem zumindest einen Halbleiter (28) und der zumindest einen Leiterplatte (16) aufweist.

2. Handwerkzeugmaschinenelektronikmodul nach Anspruch 1, **dadurch gekennzeichnet, dass** das zumindest eine Gehäusebauteil (18) zumindest einen Aufnahmebereich (20) für die zumindest eine Leiterplatte (16) bildet.

3. Handwerkzeugmaschinenelektronikmodul zumindest nach Anspruch 1, **dadurch gekennzeichnet, dass** die zumindest eine Leiterplatte (16) über den zumindest einen Abstandshalter (26) mit der zumindest einen Kühlvorrichtung (22) verbunden ist.

4. Handwerkzeugmaschinenelektronikmodul nach Anspruch 3, **dadurch gekennzeichnet, dass** der zumindest eine Abstandshalter (26) über einen Einpressvorgang mit der zumindest einen Leiterplatte (16) verbunden ist.

5. Handwerkzeugmaschinenelektronikmodul nach Anspruch 3, **dadurch gekennzeichnet, dass** der zumindest eine Abstandshalter (26) über einen Kraftschluss mit der zumindest einen Kühlvorrichtung (22) verbunden ist.

6. Handwerkzeugmaschinenelektronikmodul nach Anspruch 5, **dadurch gekennzeichnet, dass** der zumindest eine Abstandshalter (26) mit der zumindest einen Kühlvorrichtung (22) über eine lösbare Verbindung verbunden ist.

7. Handwerkzeugmaschinenelektronikmodul zumindest nach Anspruch 1, **dadurch gekennzeichnet, dass** der zumindest eine Halbleiter (28) über eine vom zumindest einen Abstandshalter (26) vermittelte Klemmverbindung mit der zumindest einen Kühlvorrichtung (22) verbunden ist.

8. Handwerkzeugmaschinenelektronikmodul zumindest nach Anspruch 1, **dadurch gekennzeichnet, dass** der zumindest eine Abstandshalter (26) die zumindest eine Leiterplatte (16) zumindest relativ zu dem Gehäusebauteil (18, 24) zentriert.

9. Handwerkzeugmaschine mit zumindest einem Handwerkzeugmaschinenelektronikmodul (10) nach den Ansprüchen 1 bis 8.

## Claims

1. Portable power tool electronic module having an electronic module housing (14), having at least one printed circuit board (16), wherein the at least one printed circuit board (16) is decoupled with reference to a movement and/or a temperature and/or a flow of power relative to at least one housing component (18) of the electronic module housing (14), having at least one cooling apparatus (22) which forms at least one housing component (24), having at least one spacer (26) formed from metal which spaces the at least one printed circuit board (16) from the at least one cooling apparatus (22), and having at least one semiconductor (28) having at least one semiconductor housing (30), which has at least one fastening element (32), with the at least one fastening element (32) positioning at least the at least one semiconductor (28), the semiconductor (28) being arranged directly on the cooling apparatus (22), wherein the at least one spacer (26) forms a thermal coupling between at least the at least one semiconductor (28) and the at least one printed circuit board (16), wherein the at least one printed circuit board (16) has a measuring apparatus (170) for indirectly determining or measuring a temperature of the semiconductor by means of the thermal coupling between at least the at least one semiconductor (28) and the at least one printed circuit board (16).

2. Portable power tool electronic module according to Claim 1, **characterized in that** the at least one housing component (18) forms at least one accommodation region (20) for the at least one printed circuit board (16).

3. Portable power tool electronic module at least according to Claim 1, **characterized in that** the at least one printed circuit board (16) is connected to the at least one cooling apparatus (22) by means of the at least one spacer (26).

4. Portable power tool electronic module according to Claim 3, **characterized in that** the at least one spacer (26) is connected to the at least one printed circuit board (16) by means of a press-in process.

5. Portable power tool electronic module according to Claim 3, **characterized in that** the at least one spacer (26) is connected to the at least one cooling apparatus (22) by means of a force-fitting connection.

6. Portable power tool electronic module according to Claim 5, **characterized in that** the at least one spacer (26) is connected to the at least one cooling apparatus (22) by means of a releasable connection.

7. Portable power tool electronic module at least according to Claim 1, **characterized in that** the at least one semiconductor (28) is connected to the at least one cooling apparatus (22) by means of a clamping connection which is created by the at least one spacer (26).

8. Portable power tool electronic module at least according to Claim 1, **characterized in that** the at least one spacer (26) centers the at least one printed circuit board (16) at least relative to the housing component (18, 24).

9. Portable power tool having at least one portable power tool electronic module (10) according to Claims 1 to 8.

## Revendications

1. Module électronique pour outil manuel motorisé, présentant
un boîtier (14) de module électronique,
au moins une carte de circuit (16), la ou les cartes de circuit (16) étant découplées par rapport à un composant (18) du boîtier (14) de module électronique en termes de déplacement, de température et/ou de passage de courant,
au moins un ensemble de refroidissement (22) qui forme au moins un composant (24) du boîtier et
au moins un écarteur (26) formé en métal qui maintient la ou les cartes de circuit (16) à distance du ou des ensembles de refroidissement (22),
au moins un semi-conducteur (28) présentant au moins un boîtier (30) de semi-conducteur qui présente au moins un élément de fixation (32), le ou les éléments de fixation (32) positionnant le ou les semi-conducteurs (28),
le semi-conducteur (28) étant disposé directement sur l'ensemble de refroidissement (22),
le ou les écarteurs (26) assurant un couplage thermique entre le ou les semi-conducteurs (28) et la ou les cartes de circuit (16),
la ou les cartes de circuit (16) présentant un ensemble de mesure (170) qui détermine et mesure indirectement la température du semi-conducteur au moyen du couplage thermique entre le ou les semi-conducteurs (28) et la ou les cartes de circuit (16).

2. Module électronique pour outil manuel motorisé selon la revendication 1, **caractérisé en ce que** le ou les composants (18) du boîtier forment au moins une zone de reprise (20) qui reprend la ou les cartes de circuit (16).

3. Module électronique pour outil manuel motorisé selon au moins la revendication 1, **caractérisé en ce que** la ou les cartes de circuit (16) sont reliées à l'ensemble ou aux ensembles de refroidissement (22) par le ou les écarteurs (26).

4. Module électronique pour outil manuel motorisé selon la revendication 3, **caractérisé en ce que** le ou les écarteurs (26) sont reliés à la ou aux cartes de circuit (16) par une opération de compression.

5. Module électronique pour outil manuel motorisé selon la revendication 3, **caractérisé en ce que** le ou les écarteurs (26) sont reliés à l'ensemble ou aux ensembles de refroidissement (22) par l'application d'une force.

6. Module électronique pour outil manuel motorisé selon la revendication 5, **caractérisé en ce que** le ou les écarteurs (26) sont reliés à l'ensemble ou aux ensembles de refroidissement (22) par une liaison libérable.

7. Module électronique pour outil manuel motorisé selon au moins la revendication 1, **caractérisé en ce que** le ou les semi-conducteurs (28) sont reliés par une liaison serrée réalisée par le ou les écarteurs (26) à l'ensemble de refroidissement (22).

8. Module électronique pour outil manuel motorisé selon au moins la revendication 1, **caractérisé en ce que** le ou les écarteurs (26) centrent la ou les cartes de circuit (16) au moins par rapport au composant (18, 24) du boîtier.

9. Outil manuel motorisé présentant au moins un module électronique (10) pour outil manuel motorisé selon les revendications 1 à 8.
